# EUROPÄISCHE PATENTANMELDUNG

(11) **EP 1 176 607 A2**
(43) Veröffentlichungstag der Anmeldung: **30.01.2002**
(21) Anmeldenummer: 01117160.0
(22) Anmeldetag: 14.07.2001
(51) Int. Cl.: G11C 29/00

(54) **Verfahrenund Vorrichtung zum Testen von Setup-Zeit und Hold-Zeit von Signalen einer Schaltung mit getakteter Datenübertragung**

(30) Priorität: 19.07.2000 DE 10035169
(71) Anmelder: Infineon Technologies AG, 81669 München (DE)
(72) Erfinder: Bucksch, Thorsten, 81534 München (DE); Schneider, Ralf, 81925 München (DE)
(74) Vertreter: Patentanwaltskanzlei WILHELM & BECK

(57) **Zusammenfassung**

Erfindungsgemäß wird zum Testen ein Referenztaktsignal an eine erste Verzögerungsstrecke mit einer festen Verzögerung und eine zweite Verzögerungsstrecke mit einer variablen Verzögerung angelegt, die jeweils mit einem Eingang der getakteten Schaltung verbunden sind, um eine Datenübertragung der getakteten Schaltung auszulösen, wobei die erste Verzögerungsstrecke ein Taktsignal und die zweite Verzögerungsstrecke ein Datensignal an die getaktete Schaltung anlegt, wobei die variable Verzögerung einen Einstellbereich Δtᵥ mit n äquidistanten Schritten und einer Grundverzögerung Δt im Bereich von [t_{F} - nΔt/2; t_{F}+ nΔt/2] aufweist und die feste Verzögerung t_{F} mindestens nΔt/2 beträgt. Zum Kalibrieren werden der Einstellbereich der variablen Verzögerung und die feste Verzögerung jeweils auf den k-fachen Wert erhöht und die variable Verzögerung wird schrittweise von n = 0 an inkrementiert, bis drei Phasenwechsel detektiert werden, wobei der Wert von n zum Zeitpunkt des ersten Phasendurchgangs der variablen Verzögerung für die Setup-Zeit und der Wert von n zum Zeitpunkt des dritten Phasendurchgangs der variablen Verzögerung für die Hold-Zeit entspricht.

## Beschreibung

Die Erfindung betrifft ein Verfahren und eine Vorrichtung zum Testen von Setup-Zeit und Hold-Zeit von Signalen einer Schaltung mit getakteter Datenübertragung.

Um eine einwandfreie Funktion bei der Datenübertragung insbesondere in Schreib/Lese-Speichern zu gewährleisten, ist es erforderlich, dass bestimmte zeitliche Rahmenbedingungen eingehalten werden. Insbesondere ist es bei der Datenübertragung wichtig, dass ein Zeitrahmen beachtet wird, in welchem das zu bewertende Signal konstant ist, um korrekt bewertet und damit eindeutig erkannt werden zu können. Dieser Zeitrahmen setzt sich aus einer Setup-Zeit und einer Hold-Zeit zusammen, wobei die Setup-Zeit dasjenige Zeitfenster bezeichnet, das zu einem relativen Zeitpunkt vor der ansteigenden oder abfallenden Flanke eines Taktimpulses beginnt und mit einem definierten Pegel der betreffenden Taktimpulsflanke endet. Unter der Hold-Zeit ist dasjenige Zeitfenster zu verstehen, das mit einem definierten Pegel der ansteigenden oder abfallenden Flanke eines Taktimpulses beginnt und zu einem relativen Zeitpunkt nach der betreffenden Flanke endet.

Die Datenmengen, die in modernen Datenübertragungssystemen beispielsweise in einem Schreib/Lese-Speicher übertragen werden sollen, werden zunehmend größer. Dies hat zur Folge, dass die Übertragungszyklen immer kürzer werden. So sind z. B. Schreib/Lese-Speicher bekannt, die Taktimpulse zur Datenübertragung mit einer Frequenz von 400MHz einsetzen, durch die eine Datenübertragungsrate von 800MHz möglich wird, da in einer Taktperiode zwei Datenübertragungen durchgeführt werden, nämlich sowohl an der ansteigenden als auch an der abfallenden Flanke des Taktimpulses. Um die übertragenen Signale bei einer solchen Übertragungsfrequenz richtig bewerten zu können, ist typischerweise ein Zeitrahmen von 400ps erforderlich, in dem die übertragenen Signale konstant sein müssen, um richtig bewertet werden zu können. Dieser Zeitrahmen ist dabei vorzugsweise in zwei symmetrische Zeitfenster um die Flanke des Taktsignals herum aufgeteilt, also in eine Setup-Zeit und eine Hold-Zeit von jeweils 200ps.

Bevor eine Schaltung mit getakteter Datenübertragung in ein Datenübertragungssystem, also z. B. ein Schreib/Lese-Speicher in einen Computer, eingebaut wird, ist es üblicherweise erforderlich die Schaltung zu testen und dabei insbesondere die Setup-Zeit und die Hold-Zeit zu bestimmen. Aufgrund der sehr kurzen Setup-Zeit bzw. Hold-Zeit z. B. bei sehr schnellen Schreib/Lese-Speichern ist ein hoher technischer Aufwand zum Testen dieser Zeitfenster erforderlich. Herkömmlicherweise müssen deshalb extrem teure Präzisionsprodukttester mit sehr hoher Testgenauigkeit eingesetzt werden.

Aus der WO 00/13186 ist ein System und ein Verfahren zum Testen von Schreib/Lese-Speichern bekannt, bei denen ein Testmodul auf dem Chip mit einem schnellen Schreib/Lese-Speicher integriert ist, um die zeitkritischen Signale zum Testen der Setup-Zeit bzw. der Hold-Zeit zu generieren. Hierbei wird mit einem an das Testmodul angeschlossenen Oszillator ein Zeitsignal an einen Taktgenerator des Testmoduls angelegt werden, der die Taktsignale zum Datentransfer des Schreib/Lese-Speichers erzeugt. Diese Taktsignale werden parallel an den zu testenden Schreib/Lese-Speicher und an eine Überwachungseinheit angelegt, wobei eine Verzögerungseinheit vorgesehen ist, die es ermöglicht, das Taktsignal relativ zu einem fest vorgegebenen Schreib- oder Lesesignal zu verschieben, um so das Zeitfenster festzulegen, in dem Daten bei der Datenübertragung konstant bleiben müssen, um korrekt bewertet werden zu können. Die Verzögerungseinheit ist dabei programmierbar ausgelegt, um sowohl die Setup-Zeit als auch die Hold-Zeit einstellen zu können.

Ein Problem bei dem bekannten Testmodul ist jedoch die exakte Programmierung der Verzögerungseinheit, um Testungenauigkeiten auszuschalten. So ist eine extrem feine Abstufung des Einstellbereichs der variablen Verzögerungseinheit gegenüber der Periode des Taktimpulses notwendig, um die Setup- bzw. die Hold-Zeit genau bestimmen zu können. Dies erfordert eine hohe Genauigkeit bei der Einstellung der Verzögerung und damit einen vergrößerten Kostenaufwand.

Aufgabe der vorliegenden Erfindung ist es deshalb ein Verfahren und eine Vorrichtung zum Testen von Setup-Zeit und Hold-Zeit von Signalen bei einer Schaltung mit getakteter Datenübertragung bereitzustellen, die sich durch einen einfachen Aufbau und eine hohe Testpräzision auszeichnet.

Diese Aufgabe wird durch ein Verfahren gemäß Anspruchs 1 und eine Vorrichtung gemäß Anspruch 3 gelöst. Bevorzugte Ausführungsformen sind in den abhängigen Ansprüchen angegeben.

Gemäß der Erfindung wird zum Testen ein Referenztaktsignal an eine erste Verzögerungsstrecke mit einer festen Verzögerung und eine zweite Verzögerungsstrecke mit einer variablen Verzögerung angelegt, die jeweils mit einem Eingang der getakteten Schaltung verbunden sind, um eine Datenübertragung der getakteten Schaltung auszulösen, wobei die erste Verzögerungsstrecke ein Taktsignal und die zweite Verzögerungsstrecke ein Datensignal an die getaktete Schaltung anlegt, wobei die variable Verzögerung einen Einstellbereich Δtᵥ mit n äquidistanten Schritten und einer Grundverzögerung Δt im Bereich von [t_{F} - nΔt/2; t_{F} + nΔt/2] aufweist und die feste Verzögerung t_{F} mindestens nΔt/2 beträgt. Zum Kalibrieren werden die Periode des Referenztaktsignals, der Einstellbereich der variablen Verzögerung und die feste Verzögerung jeweils auf den k-fachen Wert erhöht und die variable Verzögerung wird schrittweise von n = 0 an inkrementiert, bis drei Phasenwechsel detektiert werden, wobei der Wert von n zum Zeitpunkt des ersten Phasendurchgangs variablen Verzögerung für die Setup-Zeit und der Wert von n zum Zeitpunkt des dritten Phasendurchgangs variablen Verzögerung für die Hold-Zeit entspricht.

Durch diese Kalibrierungstechnik wird eine sehr einfache und genaue Festlegung der Setup-Zeit und der Hold-Zeit auch bei extrem kurzen Zeitfenstern möglich, da durch die Vervielfachung der Verzögerung in Form einer Verzögerungslupe während des Kalibrierens einer erhöhten Präzision bei der Einstellung erreicht wird.

Gemäß einer bevorzugten Ausführungsform der Erfindung kann die Kalibrierung weiterhin durch die Testschaltung selbst erfolgen, wodurch der Kalibrierungsaufwand wesentlich vermindert wird.

Gemäß einer weiteren bevorzugten Ausführungsform wird in einem zweiten Kalibrierungsdurchlauf die variable Verzögerung schrittweise von n = 0 an inkrementiert, wobei die variable Verzögerung und die feste Verzögerung nicht auf den k-fachen Wert erhöht sind, so dass nur ein Phasendurchgang auftritt. Die Differenz zwischen dem Wert von n bzw. der zugehörigen variablen Verzögerung bei diesem Phasendurchgang und dem Wert von n bzw. der zugehörigen variablen Verzögerung beim zweiten Phasendurchgang des ersten Kalibrierungsdurchlaufs entspricht der Laufzeitdifferenz zwischen den beiden Signalpfaden d. h. der festen Verzögerungsstrecke und der variablen Verzögerungsstrecke. Durch die Berücksichtigung dieser Laufzeitdifferenz zwischen den beiden Signalpfaden kann eine erhöhte Präzision bei der Einstellung der Setup-Zeit und der Hold-Zeit erreicht werden.

Die Erfindung wird anhand der beigefügten Zeichnungen näher erläutert. Es zeigen:
Figur 1 einen getakteten Datenübertragungsvorgang;
Figur 2 eine erfindungsgemäße Testschaltung zum Bestimmen von Setup-Zeit und Hold-Zeit von Signalen einer Schaltung mit getakteter Datenübertragung; und
Figur 3 drei Phasendurchgänge eines erfindungsgemäßen Kalibrierungsvorgangs mit Verzögerungslupe.

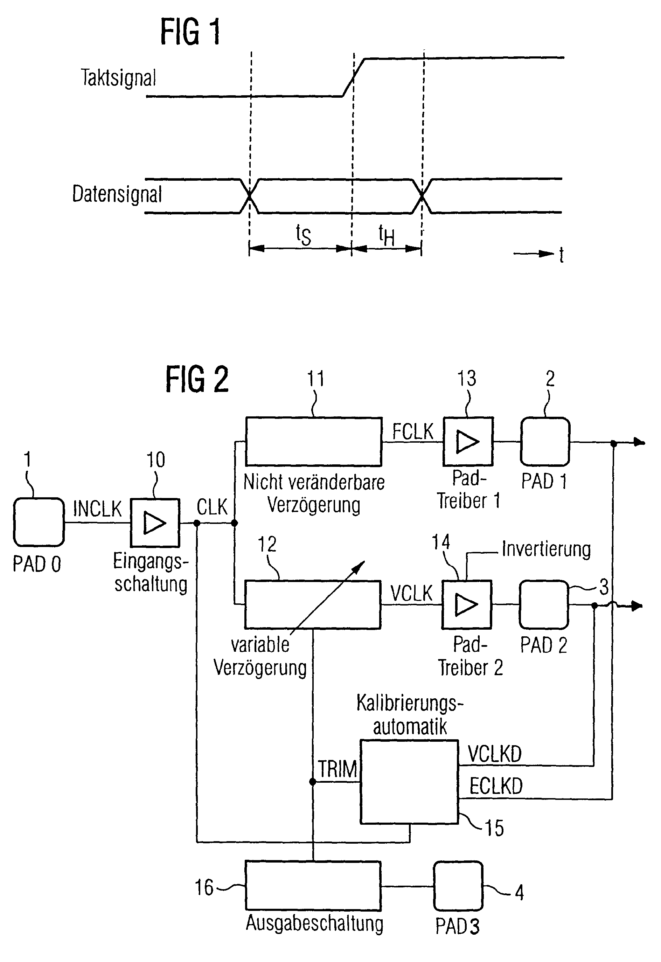

Um z. B. bei einem Schreib/Lese-Speicher eine einwandfreie Funktion zu gewährleisten, sind zeitliche Rahmenbedingungen bei der Datenübertragung einzuhalten. Figur 1 zeigt einen solchen Datenübertragungsvorgang mit einem Taktimpuls und einem zu bewertenden Datensignal. Um die Datenübertragung korrekt ausführen zu können, muss das Datensignal eine Mindestzeit gültig, d. h. stabil sein. Dieser Zeitrahmen setzt sich aus zwei festdefinierten Zeitfenstern, der Setup-Zeit t_{S} und der Hold-Zeit t_{H} zusammen, wobei die Setup-Zeit t_{S} den Zeitpunkt angibt, ab dem das Datensignal vor der ansteigenden bzw. abfallenden Flanke des Taktimpulses konstant sein muss und die Hold-Zeit t_{H} den Zeitpunkt nach dem Anstieg bzw. dem Abfallen der Flanke des Taktimpulses bis zu dem das Datensignal stabil bleiben muss. Bei schnellen Schreib/Lese-Speichern mit einer Taktfrequenz von 400MHz, bei der die Datenübertragung mit einer Frequenz von 800MHz ausgeführt werden kann, kann sowohl bei der ansteigenden als auch bei der abfallenden Flanke des Taktimpulses eine Datenübertragung stattfindet, so dass die Setup-Zeit und die Hold-Zeit typischerweise jeweils im Bereich von 200ps liegt.

Figur 2 zeigt eine mögliche Ausführungsform einer Testschaltung für eine getaktete Schaltung z. B. einem Schreib/Lese-Speicher. Die Testschaltung ist dabei vorzugsweise auf dem Chip mit der bzw. den zu überprüfenden Schaltungen integriert und weist vier Anschlüsse 1, 2, 3 und 4 auf, wobei Anschluss 1 an einen externen Signalgenerator (nicht gezeigt) angeschlossen ist, Anschlüsse 2 und 3 mit der zu testenden Schaltung (nicht gezeigt) verbunden (durch Pfeile angedeutet) sind und Anschluss 4 an eine Ausgabeeinheit (nicht gezeigt) angeschlossen ist. Durch den an Anschluss 1 angeschlossenen Signalgenerator wird ein periodisches Referenztaktsignal INCLK an eine Eingangsschaltung 10 angelegt, die das Referenztaktsignal intern puffert und das Test-Taktsignal CLK für die Testschaltung erzeugt. Dieses Taktsignal CLK wird von der Eingangsschaltung 10 parallel an ein festes Verzögerungsglied 11 und ein variables Verzögerungsglied 12 angelegt. Das feste Verzögerungsglied 11 weist eine feste Grundverzögerung t_{F} auf, das variable Verzögerungsglied 12 dagegen einen Einstellbereich Δtᵥ für die Verzögerung. Dieser Einstellbereich Δtᵥ ist in n äquidistante Abschnitte mit einer Grundverzögerung Δt unterteilt, wobei der Einstellbereich von [t_{F} - nΔt/2; t_{F} + nΔt/2] läuft. Die feste Verzögerung t_{F} des Verzögerungsglieds 11 beträgt vorzugsweise nΔt/2, kann jedoch auch ein Vielfaches davon sein. Durch diese Schaltungsauslegung ist es möglich, das vom variablen Verzögerungsglied 12 ausgegebene verzögerte Taktsignal VCLK positiv oder negativ im zeitlichen Verlauf gegenüber dem vom festen Verzögerungsglied 11 ausgegebene verzögerte Taktsignal FCLK zu verschieben.

Das vom festen Verzögerungsglied 11 ausgegebene verzögerte Taktsignal FCLK wird über eine Verstärkereinheit 13, die das Signal verstärkt, am Ausgang 2 angelegt, der mit einem ersten Eingang einer zu testenden Schaltung verbunden ist. Das durch das veränderbare Verzögerungsglied 12 ausgegebene verzögerte Taktsignal VCLK wird über eine Verstärkereinheit 14 am Ausgang 3, der mit einem zweiten Eingang der zu testenden Schaltung verbunden ist, angelegt. Die beiden Signale VCLK und FCLK lösen in der zu testenden Schaltung dann eine Datenübertragung aus, wobei das vom festen Verzögerungsglied 11 abgegebene Signal FCLK einem Taktimpuls entspricht, das vom variablen Verzögerungsglied 12 abgegebene Signal VCLK dagegen einem Datenübertragungssignal. Mit der zeitlichen Verzögerung des Signals VCLK gegenüber dem Signal FCLK wird dabei die Setup-Zeit t_{S} bzw. die Hold-Zeit t_{H} bei der Datenübertragung der zu testenden Schaltung eingestellt. Die Setup-Zeit t_{S} wird dabei getestet, wenn das Signal VCLK zu einem relativen Zeitpunkt vor dem Signal FCLK an die getaktete Schaltung angelegt wird, die Hold-Zeit t_{H} dagegen, wenn das Signal VCLK zu einem relativen Zeitpunkt nach dem Signal FCLK an die getaktete Schaltung abgegeben wird.

Die in der getakteten Schaltung ausgelöste Datenübertragung wird bewertet, wobei festgestellt wird, ob eine gültige Datenübertragung vorgenommen wurde oder nicht, d. h. ob eine Verletzung der Setup-Zeit t_{S} bzw. der Hold-Zeit t_{H} vorliegt. Bei der Datenübertragung dient das Signal FCLK des festen Verzögerungsglieds 11 als Taktsignal und das Signal VCLK des variablen Verzögerungsglieds 12 als Datensignal für die getaktete Schaltung. Die in der Testschaltung eingestellte Verzögerung zwischen diesen beiden Signalen legt die in der getakteten Schaltung zu testenden Setup-Zeit bzw. Hold-Zeit fest. Die Bewertung der Gültigkeit der Datenübertragung kann dabei in der getakteten Schaltung selbst vorgenommen werden. Alternativ besteht jedoch auch die Möglichkeit diese Bewertung in einer separaten Auswerteeinheit vorzunehmen, die Teil der Testschaltung ist.

Um die Setup-Zeit t_{S} bzw. Hold-Zeit t_{H} sowohl bei gleichphasigen als auch bei gegenphasigen Signalen d. h. bei auf- und absteigender Impulsflanke prüfen zu können, kann vor dem Anlegen der verzögerten Signale an die getaktete Schaltung eine Invertierung eines der Signale vorgenommen werden. In der in Figur 2 gezeigten Ausführungsform wird diese Invertierung mit dem Signal VCLK des variablen Verzögerungsglieds 12 vorzugsweise in der Verstärkereinheit 14 vorgenommen.

Für eine präzise Einstellung der Setup-Zeit t_{S} bzw. der Hold-Zeit t_{H} durch das gegenüber dem Signal FCLK verzögerte Signal VCLK ist es erforderlich, eine exakte Kalibrierung vorzunehmen. Dies ist insbesondere auch deshalb erforderlich, weil die Grundverzögerung Δt und die Laufzeiten auf den jeweiligen Signalpfaden des festen Verzögerungsglieds 11 und des variablen Verzögerungsglieds 12 von den Herstellungsparametern der Testschaltung abhängig sind, die sich aber nicht hinreichend genau definieren lassen. Die Kalibrierung, d.h. die Festlegung der gewünschten Setup-Zeit t_{S} bzw. der Hold-Zeit t_{H} der Testschaltung wird vorzugsweise durch die Testschaltung selbst ausgeführt, wobei die Auswerteeinheit 15 als Kalibrierungseinheit dient.

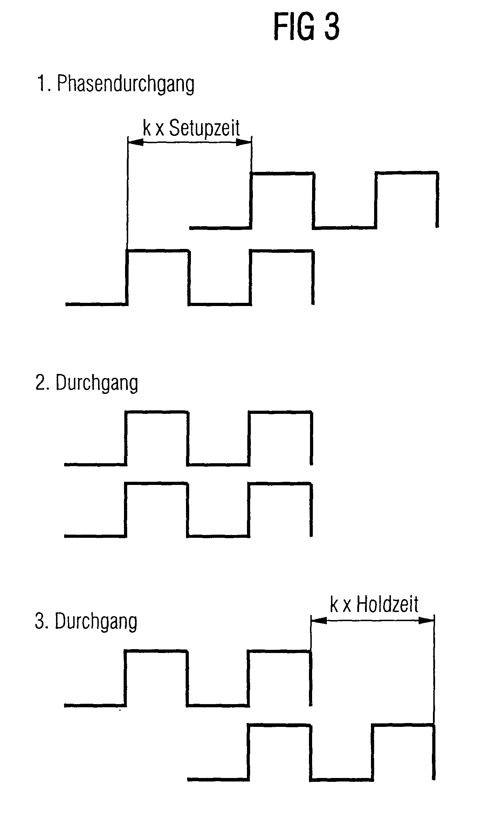

Zur Kalibrierung der Testschaltung werden zwei Kalibrierungsmessungen durchgeführt, wobei der Durchlauf der ersten Kalibrierungsmessung in Figur 3 gezeigt ist. Für die erste Kalibrierungsmessung wird, wie beim Testvorgang, das ReferenzTaktsignal INCLK über den Anschluss 1 angelegt, das über die Eingangsschaltung 10 gepuffert und in das Taktsignal CLK mit genau definierter Periode umgewandelt wird. Für die Kalibrierung wird jedoch die Periode des Taktsignals CLK gegenüber dem Testvorgang um das k-fache erhöht, d.h. die Periode des Taktsignals CLK wird auf das k-fache des einzustellenden Verzögerungswertes zum Testen der Setup- bzw. Hold-Zeit justiert. Gleichzeitig wird auch die Verzögerung t_{F} im festen Verzögerungsglied 11 auf den k-fachen Wert erhöht, so dass sich für die feste Verzögerung t_{F} ein Wert von knΔt/2 ergibt. Weiterhin wird auch der Aussteuerbereich Δtᵥ des variablen Verzögerungsglieds 12 auf den k-fachen Wert erhöht, wodurch der Aussteuerbereich Δtᵥ auf dem Bereich von [0; knΔt] festgelegt wird.

Zur Kalibrierung wird das variable Verzögerungsglied nun von n = 0 an inkrementiert, bis von der Auswerteschaltung 15, die die Phase des Signals FCLK zum Signal VCLK bewertet, drei Phasendurchgänge detektiert hat. Diese drei Phasenwechsel sind in Figur 3 gezeigt. Der erste Phasenwechsel, der von der Auswerteeinheit 15 festgestellt wird, entspricht dem k-fachen der Setup-Zeit t_{S}, der zweite Phasenwechsel zeigt die Phasengleichheit zwischen dem Signal FCLK und dem Signal VCLK an und der dritte Phasenwechsel entsteht beim k-fachen der Hold-Zeit t_{H}. Die Werte von n, zu denen diese Phasendurchgänge auftreten, werden von der Auswerteschaltung 15 gespeichert und im folgenden als n1, n2 und n3 bezeichnet. Der Wert n1 legt also die Einstellung der Setup-Zeit t_{S} und der Wert n3 die Einstellung der Hold-Zeit t_{H} in der Testschaltung fest. Durch die Kalibrierung der Setup-Zeit und der Hold-Zeit beim k-fachen der einzustellenden Verzögerungswerte, d. h. den erfindungsgemäßen Einsatz einer Art Verzögerungslupe, kann eine erhöhte Präzision bei der Einstellung dieser Werte erreicht werden.

Um gegebenenfalls auch die unterschiedlichen Laufzeiten auf den Signalpfaden des festen Verzögerungsglieds 11 und des variablen Verzögerungsglieds 12 zu berücksichtigen, wird eine zweite Kalibrierungsmessung ohne Lupenfunktion, also bei einem Wert von k = 1, durchgeführt. Hierzu wird wiederum eine Inkrementierung des Aussteuerbereichs des variablen Verzögerungsglieds 12 von n = 0 vorgenommen, wobei nur ein Phasendurchgang erfolgt. Der Wert von n bei diesem Phasenwechsel, im folgenden als n0 bezeichnet, entspricht wie der Wert n2 bei der erste Kalibrierungsmessung der Phasengleichheit zwischen dem Signal VCLK und dem Signal FCLK. Die Differenz zwischen dem Wert n2 und dem Wert n0 gibt somit den Laufzeitunterschied zwischen den beiden Signalpfaden des festen Verzögerungsglieds 11 und des variablen Verzögerungsglieds 12 wieder. Für eine korrekte Einstellung der Setup-Zeit und der Hold-Zeit müssen deshalb die Werte n1 und n2 um die Differenz Δn = n0 - n2 korrigiert werden. Es ergibt sich dann eine Setup-Zeit t_{S} ein Wert nₛ = n₁ + Δn und eine Hold-Zeit t_{H} ein Wert n_{H} = n₃ + Δn.

Um auch für eine gegenphasige Signalgenerierung eine Kalibrierung der Setup-Zeit und der Hold-Zeit durchzuführen, müssen die beiden oben dargestellten Kalibrierungsmessungen wiederholt werden, wobei eines der verzögerten Signale zu invertieren ist. Diese Invertierung muss dann in der Auswerteschaltung 15 berücksichtigt werden.

Bei den Kalibrierungsmessungen kann weiterhin die Genauigkeit der Eingangsschaltung der Auswerteeinheit 15 zusätzlich erhöht werden, da im Kalibrierungsmodus nicht die Spezifikation des zu testenden Bausteins, z. B. deren Strombegrenzung, eingehalten werden muss.

Der sich ergebende Gesamtfehler beim Testen mit der vorgestellten Testschaltung beträgt F = F_{TExt}/k + F_{Δtv}/2 + F_{Cal}, wobei F_{TExt} dem Fehler der von extern gespeisten Frequenz, F_{Δtv} der Auflösungsgrenze, bestimmt durch die Grundverzögerung Δt (in n Schritten), und F_{Cal} dem Fehlereinfluss der Kalibrierung entspricht.

Dieser Gesamtfehler kann insbesondere durch die erfindungsgemäße Kalibrierung sehr klein gehalten werden, so dass eine hohe Präzision beim Testen der Setup-Zeit und der Hold-Zeit erreicht wird.

Die in der vorstehenden Beschreibung, den Zeichnungen und den Ansprüchen offenbarten Merkmale der Erfindung, können sowohl einzeln als auch in beliebiger Kombination für die Verwirklichung der Erfindung in ihren verschiedenen Ausgestaltungen von Bedeutung sein.

## Patentansprüche

1. Verfahren zum Testen von Setup-Zeit und Hold-Zeit von Signalen einer Schaltung mit einer getakteten Datenübertragung mit den Verfahrensschritten:
zum Testen Anlegen eines Referenztaktsignals an eine erste Verzögerungsstrecke mit einer festen Verzögerung und eine zweite Verzögerungsstrecke mit einer variablen Verzögerung, wobei die erste Verzögerungsstrecke mit einem ersten Eingang einer getakteten Schaltung verbunden ist, um ein Taktsignal anzulegen, und die zweite Verzögerungsstrecke mit einem zweiten Eingang der getakteten Schaltung verbunden ist, um ein Datensignal anzulegen, wobei die variable Verzögerung einen Einstellbereich Δtᵥ mit n äquidistanten Schritten und einer Grundverzögerung Δt im Bereich von [t_{F} - nΔt/2; t_{F}+ nΔt/2] aufweist und die feste Verzögerung t_{F} mindestens nΔt/2 beträgt, und
zum Kalibrieren Erhöhen der Periode des Referenztaktsignals, des Einstellbereichs Δtᵥ der variablen Verzögerung und der feste Verzögerung t_{F} jeweils auf den k-fachen Wert und schrittweises Inkrementieren der variablen Verzögerung von n = 0 an, bis drei Phasendurchgänge detektiert werden, wobei der Wert von n zum Zeitpunkt des ersten Phasendurchgangs der variablen Verzögerung für die Setup-Zeit und der Wert n zum Zeitpunkt des dritten Phasendurchgangs der variablen Verzögerung für die Hold-Zeit entspricht.

2. Verfahren nach Anspruch 1, wobei eine weitere Kalibrierungsmessung durchgeführt wird, bei der die variable Verzögerung schrittweise von n = 0 an inkrementiert wird, bis ein Phasendurchgang auftritt, wobei die Differenz zwischen dem Wert bei diesem Phasendurchgang und den Wert beim zweiten Phasendurchgang der ersten Kalibrierungsmessung der Laufzeitdifferenz zwischen den Signalen auf der festen Verzögerungsstrecke und der variablen Verzögerungsstrecke entspricht.

3. Vorrichtung zum Testen von Setup-Zeit und Hold-Zeit von Signalen einer Schaltung mit getakteter Datenübertragung umfassend einen ersten Anschluss (1) zum Anlegen eines Referenzsignals,
eine erste Verzögerungsstrecke (11) mit einer festen Verzögerung t_{F},
eine zweite Verzögerungsstrecke (12) mit einer variablen Verzögerung,
wobei die erste Verzögerungsstrecke (11) über einen zweiten Ausgang (2) mit einem ersten Eingang der getakteten Schaltung verbunden ist, um eine Taktsignal anzulegen, und die zweite Verzögerungsstrecke (12) über einen dritten Ausgang (3) mit einem zweiten Eingang der getakteten Schaltung verbunden ist, um eine Datensignal anzulegen, wobei die variable Verzögerung einen Einstellbereich Δtᵥ mit n äquidistanten Schritten und einer Grundverzögerung Δt im Bereich von [t_{F} - nΔt/2; t_{F}+ nΔt/2] aufweist und die feste Verzögerung t_{F} mindestens nΔt/2 beträgt, und
eine Einheit (15) zum Kalibrieren der ersten Verzögerungsstrecke (11) und der zweiten Verzögerungsstrecke (12), wobei zum Kalibrieren die Periode des Referenztaktsignals, der Einstellbereich Δtᵥ der variablen Verzögerung und die feste Verzögerung t_{F} jeweils auf den k-fachen Wert erhöht werden und die variable Verzögerung schrittweise von n = 0 an inkrementiert wird, bis drei Phasendurchgänge detektiert werden, wobei der Wert von n zum Zeitpunkt des ersten Phasendurchgangs der variablen Verzögerung für die Setup-Zeit und der Wert von n vom Zeitpunkt des dritten Phasendurchgangs der variablen Verzögerung für die Hold-Zeit entspricht.

4. Vorrichtung nach Anspruch 3, wobei die Kalibrierungseinheit (15) eine weitere Kalibrierungsmessung durchführt, bei der die variable Verzögerung schrittweise von n = 0 an inkrementiert wird, bis ein Phasendurchgang auftritt und als Laufzeitdifferenz zwischen der festen Verzögerungsstrecke (11) und der variablen Verzögerungsstrecke (12) die Differenz zwischen dem Wert von n bei diesem Phasendurchgang und dem Wert von n beim zweiten Phasendurchgang der ersten Kalibrierungsmessung bestimmt wird.

5. Vorrichtung gemäß Anspruch 3 oder 4, die auf einem Chip mit der bzw. den zu überprüfenden Schaltungen integriert ist.

6. Vorrichtung nach einem der Ansprüche 3 bis 5, mit einer Eingangsschaltung (10), die mit dem ersten Anschluss (1) verbunden ist, um ein angelegtes periodisches Referenzsignal zu puffern, um daraus ein Testsignal zu erzeugen.

7. Vorrichtung nach einem der Ansprüche 3 bis 6, wobei die erste Verzögerungsstrecke (11) und die zweite Verzögerungsstrecke (12) jeweils eine Verstärkereinheit (13, 14) aufweisen.

8. Vorrichtung nach einem der Ansprüche 3 bis 7, mit einer Invertiereinrichtung, die an die erste Verzögerungsstrecke (11) oder die zweite Verzögerungsstrecke (12) angeschlossen ist, um eines der Signale zu invertieren.
